# EUROPEAN PATENT APPLICATION

(11) **EP 2 103 711 A1**
(43) Date of publication of application: **23.09.2009**
(21) Application number: 07831553.8
(22) Date of filing: 09.11.2007
(51) Int. Cl.: C23C 16/26, C23C 8/38, C23C 8/50, C23C 14/14, C23C 28/00, C23C 28/04, F16C 33/24

(54) **HIGHLY CORROSION-RESISTANT MEMBERS AND PROCESSES FOR PRODUCTION THEREOF**

(30) Priority: 28.12.2006 JP 2006356507
(71) Applicant: JTEKT Corporation, Osaka-shi Osaka 542-8502 (JP); Cnk Co., Ltd., Noda-cho Kariya-shi Aichi 448-0803 (JP)
(72) Inventor: SAITO, Toshiyuki, Osaka-shi Osaka 542-8502 (JP); SUZUKI, Masahiro, Osaka-shi Osaka 542-8502 (JP); HASHITOMI, Hiroyuki, Kariya-shi Aichi 448-0803 (JP)
(74) Representative: TBK-Patent
(86) International application number: PCT/JP2007/071822
(87) International publication number: WO 2008/081650

(57) **Abstract**

A highly corrosion-resistant member that is equipped with: a substrate made of stainless steel; an intermediate layer coated on at least a part of a surface of the substrate; and an amorphous carbon film coated on at least a part of a surface of the intermediate layer is completed by forming the intermediate layer and amorphous carbon film at such a low temperature that a temperature of the surface of the substrate is 450 °C or less. Another highly corrosion-resistant member that is equipped with: a substrate made of stainless steel, substrate whose superficial-layer portion is subj ected to nitriding treatment; and an amorphous carbon film coated on at least a part of a surface of the superficial-layer portion is completed by carrying out the nitriding treatment and a formation of the amorphous carbon film at such a low temperature that a temperature of a surface of said substrate is 450 °C or less.

In the aforementioned highly corrosion-resistant members, the surface of the substrate that is made of stainless steel is not exposed to high temperatures (> 450 °C). Consequently, the corrosion resistance of the substrate is kept equivalent to the corrosion resistance of the original stainless steel that has not been exposed to any high temperature.

## Description

### TECHNICAL FIELD

The present invention relates to a highly corrosion-resistant member that exhibits high corrosion resistance even when being employed in circumstances where corrosion is likely to occur, and to a manufacturing process for the same.

### BACKGROUND ART

Amorphous carbon (diamond-like carbon: DLC) having an amorphous structure is good in terms of mechanical characteristics, such as wear resistance and solid lubricating property, and possesses corrosion resistance, insulating property, visible light/infrared light transmissivity, oxygen barrier property, and the like, simultaneously. Accordingly, it has been often the case that an amorphous carbon film is coated onto a substrate's surface and is then used as a protective film. For example, in Patent Literature No. 1, a water-lubrication bearing is disclosed, water-lubrication bearing which moves slidably while adapting water into a lubricant liquid. The water-lubrication bearing is equipped with a rotary-side member being fixed to a rotary side, and a fixed-side member being fixed to a fixed side and facing to and contacting slidably with the rotary-side member. According to Embodiment No. 4 of Patent Literature No. 1, the fixed-side member's substrate is made of stainless steel, and a DLC film is formed on its surface.

However, it has been known that a DLC film, which is formed directly on a surface of substrate that is made of stainless steel as aforementioned, exhibits low adhesiveness to the substrate. When the adhesiveness between the DLC film and the substrate is low, it exerts adverse influences not only to the corrosion resistance but also to the sliding property. Hence, the adhesiveness has been secured heretofore by subjecting a substrate's superficial-layer portion to nitriding treatment and then forming a DLC film onto its surface. When employing such a conventional coated member in environments where corrosion is likely to occur, it has been found out that the reliability as a sliding member improves by means of the secured adhesiveness between the substrate and the DLC film; meanwhile the corrosion resistance lowers remarkably though the substrate being made of stainless steel is coated with the DLC film. Especially, in a water pump being cooling means that is annexed to internal combustion engine, although a coolant that is prepared to exhibit a pH of 9-10 approximately has been used, the coolant comes to take on acidity by means of service for a long period of time. Therefore, when the conventional coated member is employed for the water pump's constituent component parts, there might be a fear of not being endurable to long-time service.
Patent Literature No. 1: Japanese Unexamined Patent Publication (KOKAI) Gazette No. 10-184,692

### DISCLOSURE OF THE INVENTION

### Assignment to be Solved by the Invention

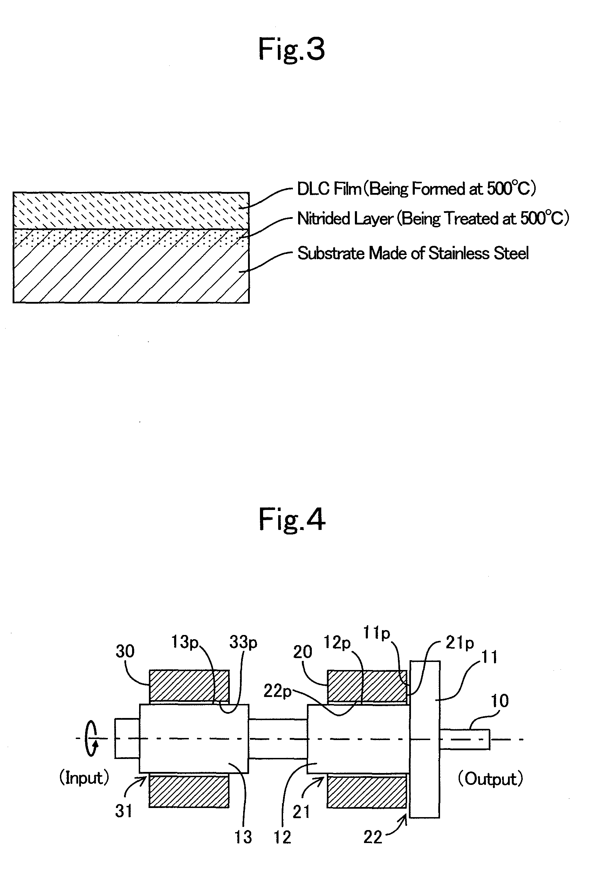

As a result of examining the aforementioned phenomena in detail, the present inventors focused their attention on the fact that the corrosion resistance of stainless steel proper has been impaired by subjecting the substrate to nitriding treatment. Fig. 3 is a cross-sectional diagram for schematically illustrating a conventional coated member whose surface is coated with an amorphous carbon film. In general, in the conventional coated member, the nitriding treatment, and the forming of the DLC film are carried out at 500 °C, or at a temperature that is higher than that. As the factors of corrosion occurrence on the conventional coated member, it is possible to think of the following two factors.

One of them is internal stress that generates in stainless steel by means of nitriding. When performing nitriding treatment onto stainless steel, nitrogen atoms diffuse through the surface of the stainless steel and then infiltrate into it, thereby generating strain (internal stress) in the crystals. In general, in metallic materials, corrosion becomes likely to occur under the conditions that bending stresses or tensile stresses are applied to them. Therefore, the surface of substrate also has a tendency to be likely to corrode because of the cause that the internal stress generates in the superficial-layer portion of stainless steel by means of nitriding.

It is the processing temperatures that exert greater influences than the internal stress does. When stainless steel is held at high temperature, chromium (Cr), an additive element being included in the stainless steel, combines with carbon (C) and the like, the additive elements thereof similarly, to form carbide and so forth, and thereby Cr deficiency layers with less Cr contents are formed around them. In the vicinities where the Cr deficiency layers are formed, since the Cr concentrations lower more than that of the original stainless steel, the stable passivation film becomes less likely to be formed, and accordingly the corrosion resistance of the stainless steel lowers locally. As a result, the stainless steel becomes likely to corrode (i.e., sensitization).

In view of the aforementioned problematic issues, it is an object for the present invention to provide a highly corrosion-resistant member that is good in terms of corrosion resistance, and a manufacturing process for the same.

### Means for Solving the Assignment

The present inventors focused their attention on one of the aforementioned factors, the sensitization of stainless steel that results from the processing temperatures. Specifically, the present inventors arrived at thinking of making it possible to retain the corrosion resistance of stainless steel by not letting the temperature of a substrate being made of stainless steel go beyond a predetermined temperature during the time period from preparing the substrate to forming an amorphous carbon film thereon.

Specifically, a highly corrosion-resistant member according to the present invention is equipped with: a substrate made of stainless steel; an intermediate layer coated on at least a part of a surface of the substrate; and an amorphous carbon film coated on at least a part of a surface of the intermediate layer; and is **characterized in that:**
said intermediate layer, and said amorphous carbon film are formed at such a low temperature that a temperature of the surface of said substrate is 450 °C or less.

Moreover, another highly corrosion-resistant member according to the present invention is equipped with: a substrate made of stainless steel, substrate whose superficial-layer portion is subjected to nitriding treatment; and an amorphous carbon film coated on at least a part of a surface of the superficial-layer portion; and is **characterized in that:**
said nitriding treatment, and a formation of said amorphous carbon film are carried out at such a low temperature that a temperature of a surface of said substrate is 450 °C or less.

A manufacturing process for highly corrosion-resistant member according to the present invention is **characterized in that** it comprises:
an intermediate-layer forming step of setting a temperature of a surface of a substrate made of stainless steel to 450 °C or less and forming an intermediate layer onto at least a part of the surface of the substrate; and
an amorphous-carbon-film forming step of setting the temperature of the surface of said substrate to 450 °C or less and forming an amorphous carbon film onto at least a part of a surface of said intermediate layer.

Moreover, another manufacturing process for highly corrosion-resistant member according to the present invention is **characterized in that** it comprises:
a low-temperature nitriding-treatment step of setting a temperature of a surface of a substrate made of stainless steel to 450 °C or less and subjecting a superficial-layer portion of the substrate to nitriding treatment; and
an amorphous-carbon-film forming step of setting the temperature of the surface of said substrate to 450 °C or less and forming an amorphous carbon film onto at least a part of a surface of said superficial-layer portion that has been subjected to the nitriding treatment.

### Effect of the Invention

In accordance with the highly corrosion-resistant members according to the present invention and the manufacturing processes for the same, the surface of the substrate made of stainless steel is not exposed to high temperatures (> 450 °C). Consequently, the corrosion resistance of the substrate is kept equivalent to the corrosion resistance of the original stainless steel that has not been exposed to any high temperature. Specifically, the highly corrosion-resistant members according to the present invention are good in terms of corrosion resistance. Note that, since an inner temperature of the substrate usually becomes lower than the surface temperature of the substrate, highly corrosion-resistant members having desirable corrosion resistance are obtainable in the present invention unless at least the surface of the substrate is exposed to the high temperatures.

It is possible to secure the adhesiveness between the substrate and the amorphous carbon film by forming the intermediate layer on at least a part of the surface of the substrate, without ever performing any nitriding treatment to the substrate. In a substrate which is not subjected to any nitriding treatment, nitrogen atoms do not diffuse/infiltrate so that no internal stress generates in the superficial-layer portion, and thereby the lowering in the corrosion resistance of the substrate is suppressed.

Moreover, by means of performing nitriding treatment onto the substrate at low temperatures (450 °C or less), the substrate is not exposed under the high temperatures, and additionally the generation of internal stress at the surface of the substrate is reduced. Consequently, the corrosion resistance of the substrate is kept equivalent to the corrosion resistance of the original stainless steel. This is because the nitriding treatment is carried out at the low temperatures and thereby the internal stress, which is generated by nitrogen atoms that diffuse and then infiltrate, becomes small.

### BRIEF DESCRIPTION OF THE DRAWINGS

Fig. 1 is a cross-sectional diagram for schematically illustrating a highly corrosion-resistance member according to the present invention;
Fig. 2 is a cross-sectional diagram for schematically illustrating another highly corrosion-resistance member according to the present invention;
Fig. 3 is a cross-sectional diagram for schematically illustrating a conventional coated member whose surface is coated with an amorphous carbon film; and
Fig. 4 is a cross-sectional diagram for schematically illustrating the bearing-structured section of water pump.

### Explanation on Reference Numerals

10: Pump Shaft (Driving Shaft);
20, 30: Bearing Metals (Bearings);
21, 31: Journal-bearing Sections; and
22: Thrust-bearing Section

### Best Mode for Carrying Out the Invention

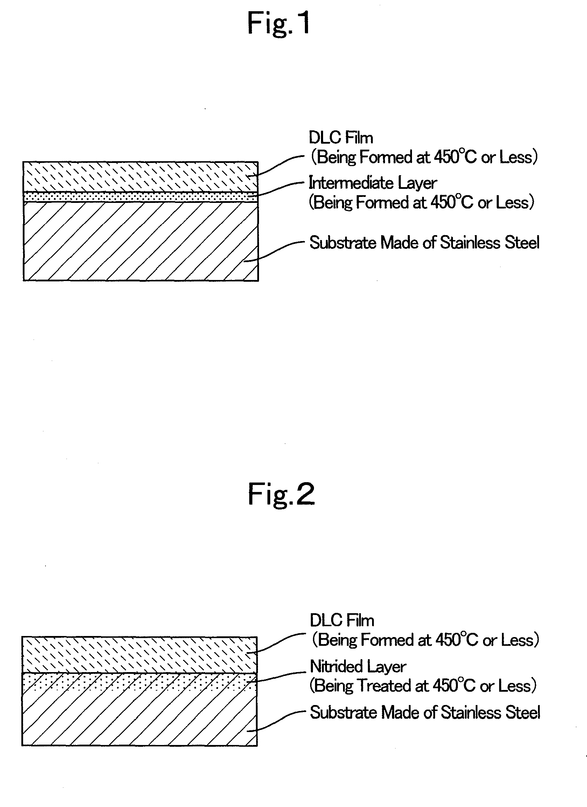

Hereinafter, highly corrosion-resistant members according to the present invention, and manufacturing processes for the same will be explained in detail. Note that Fig. 1 and Fig. 2 are cross-sectional diagrams for schematically illustrating the highly corrosion-resistant members according to the present invention.

### (Highly Corrosion-resistant Members)

A highly corrosion-resistant member according to the present invention is equipped with a substrate made of stainless steel, an intermediate layer coated on at least a part of a surface of the substrate, and an amorphous carbon film coated on at least a part of a surface of the intermediate layer (Fig. 1). Alternatively, another highly corrosion-resistant member according to the present invention is equipped with a substrate made of stainless steel, substrate whose superficial-layer portion is subjected to nitriding treatment, and an amorphous carbon film coated on at least a part of a surface of the superficial-layer portion (Fig. 2).

The substrate is not limited particularly in its shape and size, as far as it is made of stainless steel. Moreover, the type of stainless steel is not limited particularly, and it is allowable to select it from general martensite-system, ferrite-system or austenite-system stainless steels, two-phase stainless steels, and the like, depending on applications.

Moreover, a surface roughness of the substrate is not limited inparticular. However, whenthehighlycorrosion-resistantmembers are employed as a sliding component part, it is allowable that its ten-point average surface roughness Rz (JIS) can be 0.4-6.3 µm, from the viewpoint of the adhesiveness between the substrate and the intermediate layer or amorphous carbon film, and from that of the sliding property.

In the substrate, it is even allowable that the superficial-layer portion can be subjected to nitriding treatment. As will be detailed later, the nitriding treatment is carried out at a low temperature of 450 °C or less. Although an extent of the nitriding treatment is not limited particularly, it is allowable that a nitrided depth can be 10 µm or more, further 20-30 µm. When being 10 µm or more, the amorphous carbon film to be formed on the surface is prevented from coming off effectively, because nitriding is done fully onto the entire surface of the substrate to which nitriding is needed.

The intermediate layer that is coated on at least a part of the surface of the substrate improves the adhesiveness between the substrate and the amorphous carbon film (DLC film). It is allowable that the intermediate layer can be a hard coated film whose adhesiveness to the substrate and DLC film is high. For example, it is possible to name metallic coated films, such as chromium (Cr) films, titanium (Ti) films, silicon (Si) films and tungsten (W) films; or carbide films, nitride films or carbonitride films that include at least one member of Cr, Ti, Si and W. As specific examples of the carbide films, nitride films and carbonitride films, it is possible to name WC films, SiC films, SiC/CrN films, CrN films, TiN films, TiN/CrN films, TiCrN films, and so forth.

Although a thickness of the intermediate layer is not limited particularly, it can preferably be 50 nm or more, further preferably 50-200 nm. When being 50 nm or more, the adhesiveness between the substrate and the DLC film is secured.

The amorphous carbon film (DLC film) is coated on at least a part of the surface of the intermediate layer, or on at least a part of the surface of the substrate's superficial-layer portion that has been subjected to nitriding treatment.

The DLC film fulfils a role as a protective layer for improving the corrosion resistance. The DLC film is not limited particularly as far as it comprises carbon (C) primarily and has an amorphous structure, and it is even allowable to include elements that are less likely to be corroded, such as molybdenum (Mo), tungsten (W), tantalum (Ta), niobium (Nb), silicon (Si), boron (B), titanium (Ti), chromium (Cr) and nitrogen (N), in addition to hydrogen (H). In particular, a DLC-Si film that includes Si exhibits not only corrosion resistance but also low friction coefficient and high wear resistance. Further, since its aggressiveness to mating member is low, the highly corrosion-resistant members according to the present invention, highly corrosion-resistant members which are equipped with a DLC-Si film, are suitable for sliding component part in which a surface of the DLC-Si film is adapted into a sliding surface.

Although a thickness of the DLC film is not limited particularly, it can preferably be 500 nm or more, further preferably 500-3, 000 nm. When being 500 nm or more, it naturally exhibits not only corrosion resistance as a protective film but also sufficient sliding property as a sliding layer.

Since the highly corrosion-resistant members according to the present invention have good corrosion resistance, it is feasible to employ them as constituent component parts of various apparatuses that are used in environments where corrosion is likely to occur. For example, the highly corrosion-resistant members according to the present invention are suitable for constituent component parts that are employed in the presence of liquid including water. In particular, since the highly corrosion-resistant members according to the present invention have the DLC film that exhibits good sliding characteristics, they can preferably be sliding component parts in which a surface of the DLC film contacts slidably with a mating material. On this occasion, the sliding component parts are employed in the presence of liquid including water, and slide while making a lubricant liquid of the liquid including water. It is even allowable that the liquid including water can be a coolant that is used for cooling internal combustion engine. The coolant is usually employed after diluting a coolant stock solution with water.

As a specific example of the sliding component parts, it is possible to name driving shafts, bearings, pistons, cylinders, valves, and the like. As for a driving shaft and bearing that are used in environments where corrosion is likely to occur, bearing-structured sections of water pump for transporting water or liquid (coolant, for instance) including water are available. A water pump is mounted onto an automobile as a cooling means for internal combustion engine to use, for instance. A bearing-structured section of the water pump is equipped with a rotary shaft on which a pulley is fixed at one of the opposite ends and an impeller is fixed at the other one of the opposite ends, and a bearing member for supporting the rotary shaft rotatably. Usually, the bearing-structured section is disposed in a housing for accommodating the other opposite-end side of the rotary shaft. Specifically, the housing is equipped with an accommodation space for accommodating the other opposite-end side of the rotary shaft, and a through hole which is communicated with the accommodation space and into which the rotary shaft is fitted; and the bearing member is fixed on a peripheral-wall portion of the through hole. Although the bearing member can preferably be a slide bearing, it is allowed to be various bearing devices, such as ball bearings and roller bearings. When the bearing member is a slide bearing, it is preferable that the rotary shaft and/or the bearing member can comprise one of the highly corrosion-resistant members according to the present invention, and it is allowable to place a surface of the aforementioned DLC film in at least one of an outer peripheral surface of the rotary shaft and a bearing surface of the bearing member, outer peripheral surface and bearing surface which contact slidably with each other. When they make a bearing-structured section of water pump, as for the stainless steel to be used for the substrate, it is allowable to use SUS304, SUS630, SUS440C, SUS303, SUS316, and so forth, (JIS).

And, the intermediate layer, and the DLC film are formed at such a low temperature that a temperature of the surface of the substrate is 450 °C or less (Fig. 1). Likewise, the nitriding treatment, and the formation of the DLC film are carried out at such a low temperature that a temperature of the surface of the substrate is 450 °C or less (Fig. 2). The formations of the intermediate layer and DLC film, and the nitriding treatment will be detailed in the section of (Manufacturing Processes for Highly Corrosion-resistant Member).

In the highly corrosion-resistant members according to the present invention, the substrate is made of stainless steel. As described above, stainless steel is sensitized by being retained at high temperatures. For example, in the case of SUS304, although the sensitization temperature is said to be 500-800 °C, the sensitization temperature differs depending on the amounts of additive elements included in the stainless steel, for instance, depending on the C content. When a temperature of a surface of the substrate is set at 450 °C or less, desirably at 250 °C or less, further desirably at 200 °C or less, and then the nitriding treatment or the formations of the intermediate layer and DLC film are carried out, it is believed that the sensitization is suppressed in most of stainless steels. When the temperature of the surface of the substrate does not go beyond 450 °C, the sensitization of the stainless steel is suppressed even if the substrate is heated for a time required for the nitriding treatment or the formations of the intermediate film and DLC film (30-180 minutes). Note that, in the highly corrosion-resistant members according to the present invention, highly corrosion-resistant members having desired corrosion resistance are obtainable when the nitriding treatment or the formations of the intermediate film and DLC film are carried out for 30-180 minutes in any one of them, though depending on the processing methods or film-forming methods.

### (Manufacturing Processes for Highly Corrosion-resistant Member)

The manufacturing processes for highly corrosion-resistant member according to the present invention are manufacturing processes for the highly corrosion-resistant members according to the present invention that have been explained so far.

One of the manufacturing processes for high corrosion-resistant member according to the present invention comprises an intermediate-film forming step, and an amorphous-carbon-film forming step.

The intermediate-layer forming step is a step of setting a temperature of a surface of a substrate made of stainless steel to 450 °C or less and forming an intermediate layer onto at least a part of the surface of the substrate. In the intermediate-layer forming step, it is allowable to set a temperature of some of the surface of the substrate which is required to be corrosion resistance to 450 °C or less. Note that, since the influence of heat is less inside the substrate compared with that in the surface of the substrate as far as being ordinary processing, the temperature does not go beyond 450 °C even at any part of the substrate when the temperature of the surface of the substrate is 450 °C or less. From here on, the temperature of the surface of the substrate may be set forth as a "film-forming temperature" or "processing temperature."

The method of forming an intermediate layer is not limited in particular as far as being a method that makes it possible to form an intermediate layer so as not to let the temperature of the surface of the substrate go beyond 450 °C, and accordingly it is allowable to select it depending on the type of intermediate layers. Moreover, it is preferable to form a film of the intermediate layer at 70 °C or more from the viewpoint of adhesiveness. In general, the formation of coated films is feasible at lower temperatures by physical vapor deposition methods (PVD methods) than by chemical vapor deposition methods (CVD methods). Consequently, it is desirable to form the intermediate layer using a PVD method. To be concrete, vacuum deposition by means of electron beam, laser abrasion, or the like; sputtering such as magnetron sputtering; ion plating, and the like, can be named. In particular, an unbalanced magnetron sputtering method is a film-forming method that makes it possible to form dense coated films. Moreover, when being a CVD method by which low-temperature film forming is feasible, it is possible to use it as a method of forming the intermediate layer. For example, it can desirably be a hot-cathode PIG plasma CVD method (PIG: penning ionization gauge), because it is possible to form the intermediate layer in such a range that the temperature of the surface of the substrate is 170-300 °C.

The amorphous-carbon-film forming step is a step of setting the temperature of the surface of the substrate to 450 °C or less and forming an amorphous carbon film onto at least a part of a surface of the intermediate layer. In this instance, when setting a temperature of the surface of the intermediate layer to 450 °C or less and forming a DLC film, the temperature of the surface of the substrate does not go beyond 450 °C so that the stainless steel is not sensitized at all. The method of forming a DLC film is not limited in particular as far as being a method that makes it possible to form a DLC film so as not to let the temperature of the surface of the substrate go beyond 450 °C. Moreover, it is preferable to form a DLC film at 150 °C or more from the viewpoint of adhesiveness. As described above, the formation of coated films is generally feasible at lower temperatures by physical vapor deposition methods (PVD methods) than by chemical vapor deposition methods (CVD methods). Consequently, it is desirable to form the DLC film, too, using a PVD method. To be concrete, vacuum deposition by means of electron beam, laser abrasion, or the like; sputtering such as magnetron sputtering; ion plating, and the like, can be named. In particular, since an unbalanced magnetron sputtering method is a film-forming method that makes it possible to form DLC films that are not only dense but also exhibit high protective effect, it is a suitable method as the manufacturing processes for highly corrosion-resistant member according to the present invention. Moreover, when being a CVD method by which low-temperature film forming is feasible, it is possible to use it as a method of forming the DLC film. For example, it can desirably be the above-described hot-cathode PIG plasma CVD method, because it is possible to form the DLC film in such a range that the temperature of the surface of the substrate is 170-300 °C.

Another one of the manufacturing processes for high corrosion-resistant member according to the present invention comprises a low-temperature nitriding-treatment step, and an amorphous-carbon-film forming step.

The low-temperature nitriding-treatment step is a step of setting a temperature of a surface of a substrate made of stainless steel to 450 °C or less and subjecting a superficial-layer portion of the substrate to nitriding treatment. At the low-temperature nitriding-treatment step, it is allowable to subject the substrate to nitriding treatment at a processing temperature of 450 °C or less. As far as the temperature of the surface of the substrate to be subjected to nitriding treatment is 450 °C or less, the superficial-layer portion is also kept at 450 °C or less.

As for a method of the nitriding treatment, gas nitriding methods, salt-bath nitriding methods, ion nitriding methods, and the like, are available. Of these, the gas nitriding methods are not appropriate for another one of the manufacturing processes for high corrosion-resistant member according to the present invention, because they are carried out by heating the substrate to 500-600 °C in ammonia gas. On the contrary, it is feasible for the salt-bath nitriding methods to set a temperature of the superficial-layer portion of the substrate to 450 °C or less and then do nitriding treatment depending on the type of molten salts, because they are carried out by immersing the substrate into a molten salt that includes cyanide. Moreover, ion nitriding methods by means of ion implantation is desirable, because it is carried out by retaining the substrate in nitrogen plasma in which nitrogen-containing gas is ionized so that nitriding becomes feasible at low temperatures of 450 °C or less. In addition, liquid nitriding methods using ammonia water is desirable because processing at around room temperature is also feasible, though the nitriding rate is slow compared with those of the other methods. The liquid nitriding methods at 20-80 °C are desirable, because the internal stress that generates in the stainless steel is reduced. A processing temperature for nitriding can desirably be from room temperature or more to 450 °C or less, further desirably be from 300 °C or less to 450 °C or less. When being 300 °C or more, nitrided layers with sufficient depths are formed in a short period of time.

The amorphous-carbon-film forming step is a step of setting the temperature of the surface of the substrate to 450 °C or less and forming a DLC film onto at least a part of a surface of the superficial-layer portion that has been subjected to the nitriding treatment. The method of forming a DLC film is not limited in particular as far as being a method that makes it possible to form a DLC film so as not to let the temperature of the surface of the substrate, namely, the temperature of the surface of the superficial-layer portion that has been subjected to the nitriding treatment, go beyond 450 °C. Moreover, it is preferable to form a DLC film at 150 °C or more from the viewpoint of adhesiveness. As described above, the formation of coated films is generally feasible at lower temperatures by physical vapor deposition methods (PVD methods) than by chemical vapor deposition methods (CVD methods). Consequently, it is desirable to form the DLC film, too, using a PVD method. To be concrete, vacuum deposition by means of electron beam, laser abrasion, or the like; sputtering such as magnetron sputtering; ion plating, and the like, can be named. In particular, since an unbalanced magnetron sputtering method is a film-forming method that makes it possible to form DLC films that are not only dense but also exhibit high protective effect, it is a suitable method as the manufacturing processes for highly corrosion-resistant member according to the present invention. Moreover, when being a CVD method by which low-temperature film forming is feasible, it is possible to use it as a method of forming the DLC film. For example, it can desirably be the above-described hot-cathode PIG plasma CVD method, because it is possible to form the DLC film in such a range that the temperature of the surface of the substrate is 170-300 °C.

So far, the embodiment modes of the highly heat-resistant members according to the present invention and the manufacturing processes for the same have been explained, however, the present invention is not one which is limited to the aforementioned embodiment modes. They can be conducted in various modes to which modifications, improvements, and the like, which one of ordinary skill in the art can carry out, are performed, within a range not departing from the scope of the present invention. For example, it is allowable as well to carry out a process for roughening the surface of the substrate or a process for cleaning the surface of the substrate, and so forth.

### EMBODIMENT

Next, the present invention will be explained in more detail while naming a specific embodiment.

In an embodiment and a comparative example that will be explained hereinafter, a driving shaft in a bearing-structured section of water pump was made. The bearing-structured section of water pump is illustrated in Fig. 4.

The bearing-structured section of water pump is equipped with a pump shaft 10 (i.e., a driving shaft), and bearing metals 20 and 30 that support the pump shaft 10 rotatably.

The pump shaft 10 possesses: a disk-shaped flange portion 11 that extends in the axially central direction; a first major-diameter portion 12 that neighbors the flange portion 11; and a second maj or-diameter portion 13 that is placed with an intervening space between itself and the first major-diameter portion 12; in this order from the output side. Both of the bearing metals 20 and 30 are shaped cylindrically, and the major-diameter portion 12 and second major-diameter portion 13 of the pump shaft 10 are fitted into the cylinders, respectively. On this occasion, one of the opposite surfaces of the bearing metal 20, an end surface 21p, comes in contact with a flat surface 11p that is placed on the input side of the flange portion 11. Therefore, a journal bearing portion 21 in which an outer peripheral surface 12p of the first major-diameter portion 12 of the pump shaft 10 contacts with an inner peripheral surface 22p of the bearing metal 20 slidably; and a thrust bearing portion 22 in which the flat surface 11p of the flange portion 11 contacts with the end surface 21p of the bearing metal 20 slidably; are constituted of the pump shaft 10 and bearing metal 20. Moreover, a journal bearing portion 31 in which an outer peripheral surface 13p of the second major-diameter portion 13 of the pump shaft 10 contacts with an inner peripheral surface 33p of the bearing metal 30 slidably is constituted of the pump shaft 10 and bearing metal 30.

The pump shaft 10 comprised a substrate that was made of stainless steel (SUS304), and was completed by forming an intermediate layer or nitrided layer, and a DLC film onto the substrate's outer peripheral surface. A surface roughness of the outer peripheral surface of the substrate of the pump shaft 10 was Rz 1.6 µm. Note that the bearing metals 20 and 30 comprised a substrate of stainless (SUS304), and that none of the intermediate layer, nitrided layer and DLC film were formed.

### (Embodiment No. 1)

In the present embodiment, a titanium film (intermediate layer) and a DLC film were formed onto the outer peripheral surface of the substrate by the following procedures, thereby making the pump shaft 10 shown in Fig. 4.

Note that, for the formations of the titanium film and DLC film, a PIG-type plasma CVD apparatus that was produced by SHINKOH SEIKI Co., Ltd. ("APIG-1060D," hereinafter abbreviated to as "PIG") was used. The PIG apparatus had a plasma source that comprised a hot-cathode filament and an anode. A raw-material gas that was introduced into the apparatus was decomposed and then dissociated by means of plasma that was generated at the plasma source, and was thereby turned into a film onto a substrate's surface (i.e., a hot-cathode PIG plasma CVD method). Moreover, since a sputtering cathode that was connected with a direct-current electric source is disposed within this PIG apparatus, a film forming by means of direct-current sputtering method was feasible. The substrate's surface temperature was measured by means of a thermocouple that was put in place adjacent to the substrate.

First of all, a substrate was put in place within the PIG apparatus's chamber, and the inside of the chamber was depressurized to a predetermined pressure. Next, electricity was supplied to the plasma source, and additionally an argon gas was introduced into the chamber, thereby forming plasma within the chamber. Under the circumstances, the substrate's surface was subjected to ion-bombarding processing (20 minutes).

After the ion-bombarding processing, direct-current electricity was supplied to the sputtering cathode on which a target material comprising Ti was placed. Bymeans of 40-minute film forming, a titanium film with 100-nm film thickness was formed on the substrate's outer peripheral surface (i.e., Step I).

After the titanium film was formed to the desired film thickness, the supply of direct-current electricity was stopped. Thereafter, a tetramethylsilane (TMS) gas was introduced into the chamber. The introduced TMS gas was decomposed and then dissociated by means of plasma that was generated at the plasma source to which electricity was supplied, and thereby a DLC film including Si (DLC-Si film: 3, 000-nm film thickness) was formed onto the substrate' s outer peripheral surface by means of 70-minute film forming (i.e., Step II).

Note that the processing temperature for the ion-bombarding processing was 300 °C, and that the temperature of the substrate's surface was 200 °C at Step I and Step II.

### (Comparative Example No. 1)

In the present comparative example, a substrate was subjected to nitriding treatment and thereafter a DLC film was formed by the following procedures, thereby making the pump shaft 10 shown in Fig. 4.

Notethat, for the nitriding treatment and DLC-film formation, a direct-current plasma CVD apparatus that was produced by CNK Co. , Ltd. ("JPC-3000S," hereinafter abbreviated to as "PCVD") was used. The substrate's surface temperature was measured by means of a radiation thermometer.

First of all, a substrate was put in place within the PCVD apparatus' s chamber, and the inside of the chamber was depressurized to a predetermined pressure. Thereafter, a direct-current voltage was applied between the substrate and an anode plate that was laid on the chamber's inner side, thereby starting electric discharge. And, a temperature rise was carried out by means of ion bombardment until the substrate's surface became a nitriding-treatment temperature (500 °C). Next, a nitrogen gas, and a hydrogen gas were introduced into the chamber, thereby carrying out plasma-nitriding treatment (60 minutes). Upon observing the thus obtained substrate' s cross-sectional structure, the nitrided depth was about 20 µm (i.e., Step I).

After finishing the plasma-nitriding treatment, the supply of the nitrogen gas was stopped, and then a TMS gas and a hydrogen gas were supplied into the chamber. A DLC film including Si (DLC-Si film: 3, 000-nm film thickness) was formed onto the substrate' s outer peripheral surface by means of 50-minute film forming (i.e., Step II).

### (Comparative Example No. 2)

In the present comparative example, the formations of the intermediate layer and DLC film, and the nitriding treatment were not carried onto a substrate at all. That is, the resultant driving shaft was an unprocessed substrate.

### (Evaluation)

In order to evaluate the driving shafts according to embodiments and comparative examples, a corrosion test was carried out. In the corrosion test, the bearing-structured sections of water pump that comprised the pump shafts 10 (i.e., driving shafts) being made as above and the bearing metals 20 and 30 were left as they were in 80 °C water for 24 hours, and then their evaluations were carried out by visually observing the presence or absence of subsequent corrosion on them.

The evaluation results are given Table 1. Note that, in Table 1, "absence" indicates those in which no change was appreciated between the start of the corrosion test and 24 hours later; and "presence" indicates those in which discolorations were confirmed on the bearing-structured sections' surface and in water after 24 hours.

**(TABLE 1)**

| | | Embodiment No. 1 | Comp. Ex. No. 1 | Comp. Ex. No. 2 |
|---|---|---|---|---|
| Substrate | | SUS304 | SUS304 | SUS304 |
| Step I | Type of Processing | Formation of Intermediate Layer | Nitriding Treatment | - |
| | Type of Coated Film | Titanium Film | (Nitrided Layer) | - |
| | Thickness of Coated Film (nm) | 100 | (2000)^{*} | - |
| | Processing Temp (°C) | 2CO | 500 | - |
| Step II | Type of Processing | Formation of DLC Film | Formation of DLC Film | - |
| | Type of Coated Film | DLC-Si Film | DLC-Si Film | - |
| | Thickness of Coated Film (nm) | 3000 | 3000 | - |
| | Processing Temp. (°C) | 200 | 500 | - |
| Employed Apparatus | | PIG | PCVD | - |
| Evaluation (Presence or Absence of Corrosion) | | Absence | Presence | Absence |

| | | | | |
|---|---|---|---|---|
| *: Being a depth of nitriding from the substrate's surface | | | | |

In the bearing-structured section according to Embodiment No. 1 in which the processing temperatures were 200 °C at Step I and Step II, no corrosion was confirmed. Moreover, in the unprocessed bearing-structured section (Comparative Example No. 2) as well, no corrosion was confirmed. On the contrary, in the bearing-structured section according to Comparative Example in which the processing temperatures were 500 °C at Step I and Step II, rust was confirmed on its surface, and additionally the color of water discolored. That is, it was understood that the substrate' s corrosion resistance can be kept by setting the processing temperatures to 450 °C or less at Step I and Step II.

## Claims

1. A highly corrosion-resistant member being equipped with: a substrate made of stainless steel; an intermediate layer coated on at least a part of a surface of the substrate; and an amorphous carbon film coated on at least a part of a surface of the intermediate layer; the highly corrosion-resistant member being **characterized in that:**
said intermediate layer, and said amorphous carbon film are formed at such a low temperature that a temperature of the surface of said substrate is 450 °C or less.

2. A highly corrosion-resistant member being equipped with: a substrate made of stainless steel, substrate whose superficial-layer portion is subjected to nitriding treatment; and an amorphous carbon film coated on at least a part of a surface of the superficial-layer portion; the highly corrosion-resistant member being **characterized in that:**
said nitriding treatment, and a formation of said amorphous carbon film are carried out at such a low temperature that a temperature of a surface of said substrate is 450 °C or less.

3. The highly corrosion-resistant member as set forth in claim 1 or 2 being a sliding component part, which is employed in the presence of liquid including water and in which a surface of said amorphous carbon film contacts slidably with a mating material.

4. The highly corrosion-resistant member as set forth in claim 3, wherein said liquid is a coolant that is diluted with water.

5. The highly corrosion-resistant member as set forth in claim 3, wherein said sliding component part is a driving shaft and/or a bearing.

6. The highly corrosion-resistant member as set forth in claim 5, wherein said driving shaft, and said bearing are a bearing-structured section of water pump for transporting said liquid.

7. The highly corrosion-resistant member as set forth in claim 1, wherein said intermediate film is a chromium (Cr) film, a titanium (Ti) film, a silicon (Si) film, a tungsten (W) film, or a carbide film, nitride film or carbonitride film that includes at least one member of Cr, Ti, Si and W.

8. A manufacturing process for highly corrosion-resistant member, the manufacturing process being **characterized in that** it comprises:
an intermediate-layer forming step of setting a temperature of a surface of a substrate made of stainless steel to 450 °C or less and forming an intermediate layer onto at least a part of the surface of the substrate; and
an amorphous-carbon-film forming step of setting the temperature of the surface of said substrate to 450 °C or less and forming an amorphous carbon film onto at least a part of a surface of said intermediate layer.

9. A manufacturing process for highly corrosion-resistant member, the manufacturing process being **characterized in that** it comprises:
a low-temperature nitriding-treatment step of setting a temperature of a surface of a substrate made of stainless steel to 450 °C or less and subjecting a superficial-layer portion of the substrate to nitriding treatment; and
an amorphous-carbon-film forming step of setting the temperature of the surface of said substrate to 450 °C or less and forming an amorphous carbon film onto at least a part of a surface of said superficial-layer portion that has been subjected to the nitriding treatment.

10. The manufacturing process for highly corrosion-resistant member as set forth in claim 8, wherein said intermediate-layer forming step is a step of forming said intermediate layer by means of physical vapor deposition method.

11. The manufacturing process for highly corrosion-resistant member as set forth in claim 9, wherein said low-temperature nitriding-treatment step is a step of carrying out the nitriding treatment by means of ion nitriding method by means of ion implantation, or by means of liquid nitriding method using ammonia water.

12. The manufacturing process for highly corrosion-resistant member as set forth in claim 8 or 9, wherein said amorphous-carbon-film forming step is a step of forming said amorphous carbon film by means of physical vapor deposition method.

13. The manufacturing process for highly corrosion-resistant member as set forth in claim 8 or 9, wherein said highly-corrosion resistant member is a sliding component part, which is employed in the presence of liquid including water and in which a surface of said amorphous carbon film contacts slidably with a mating material.

14. The manufacturing process for highly corrosion-resistant member as set forth in claim 13, wherein said liquid is a coolant that is diluted with water.

15. The manufacturing process for highly corrosion-resistant member as set forth in claim 13, wherein said sliding component part is a driving shaft and/or a bearing.

16. The manufacturing process for highly corrosion-resistant member as set forth in claim 15, wherein said driving shaft, and said bearing are a bearing-structured section of water pump for transporting said liquid.

17. The manufacturing process for highly corrosion-resistant member as set forth in claim 8, wherein said intermediate film is a chromium (Cr) film, a titanium (Ti) film, a silicon (Si) film, a tungsten (W) film, or a carbide film, nitride film or carbonitride film that includes at least one member of Cr, Ti, Si and W.
